# EUROPEAN PATENT APPLICATION

(11) **EP 4 597 256 A1**
(43) Date of publication of application: **06.08.2025**
(21) Application number: 25150370.2
(22) Date of filing: 06.01.2025
(51) Int. Cl.: G06F 1/16, G06F 1/20, H05K 7/20

(54) **ELECTRONIC APPARATUS**

(30) Priority: 02.02.2024 JP 2024014915
(71) Applicant: Lenovo (Singapore) Pte. Ltd, New Tech Park 556741 (SG)
(72) Inventor: WANG, Hao-Yu, Yokohama-shi, 220-0012 (JP); SAIGUSA, Yuki, Yokohama-shi, 220-0012 (JP); YOSHIZAWA, Hajime, Yokohama-shi, 220-0012 (JP); YANG, Xueyong, Yokohama-shi, 220-0012 (JP)
(74) Representative: Openshaw & Co.

(57) **Abstract**

An object of the present disclosure is to provide an electronic apparatus capable of suppressing the surface temperature of a chassis and improving space efficiency inside the chassis. The electronic apparatus includes: a chassis; a heat generating element provided in the chassis; and a cooling module that is provided in the chassis and cools the heat generating element. The cooling module has: a heat diffusion member that absorbs and diffuses heat from the heat generating element; and a pair of fans that are placed with the heat diffusion member located therebetween, and have discharge ports provided only in side surfaces facing each other, thereby making it possible to discharge air toward the heat diffusion member. The chassis has an outer wall that extends along a placement direction of the pair of fans and has an exhaust port formed therein, and the exhaust port is positioned between the pair of fans in the case where the placement direction is taken as a reference.

## Description

### BACKGROUND OF THE INVENTION

### Field of the Invention

The present invention relates to an electronic apparatus provided with a cooling module.

### Description of the Related Art

An electronic apparatus such as a laptop PC includes a heat generating element such as a CPU. This type of electronic apparatus usually includes a cooling module provided with a fan or a heat sink to absorb the heat generated by a heat generating element and dissipates the absorbed heat to the outside (refer to, for example, Japanese Patent No. 7371170).

### SUMMARY OF THE INVENTION

The cooling module of Japanese Patent No. 7371170 includes a pair of left and right fans and a pair of heat sinks placed immediately behind discharge ports facing the back of the fans. The heat sinks transport the heat from a heat generating element through a heat pipe, and dissipate the heat to the outside of chassis by the air blown by the fans. In other words, the heat from the heat generating element is concentrated in the heat sinks. Therefore, the surface temperature of the chassis may become locally high directly above or below the heat sinks. In particular, the surface temperatures of chassis that have been significantly made thinner in recent years are more likely to easily increase.

Furthermore, in the configuration in Japanese Patent No. 7371170, the heat sinks are installed behind the fans, so that the heat sinks eat into the space inside the chassis. This leads to the problem that, for example, it becomes difficult to secure installation space for a battery device and various devices to be placed toward the front of the chassis.

The present invention has been made in view of the problem with the prior art described above, and it is an object of the invention to provide an electronic apparatus capable of suppressing the surface temperature of a chassis and improving space efficiency inside the chassis.

An electronic apparatus according to an aspect of the present invention includes: a chassis; a heat generating element provided in the chassis; and a cooling module that is provided in the chassis and cools the heat generating element, wherein the cooling module has: a heat diffusion member that absorbs and diffuses heat from the heat generating element; and a pair of fans that are placed with the heat diffusion member located therebetween, and have discharge ports only in side surfaces facing each other, thereby making it possible to discharge air toward the heat diffusion member, the chassis has an outer wall that extends along a placement direction of the pair of fans and has an exhaust port formed therein, and the exhaust port is positioned between the pair of fans in the case where the placement direction is taken as a reference.

According to the above-described aspect of the present invention, the surface temperature of a chassis can be suppressed and the space efficiency inside the chassis can be improved.

### BRIEF DESCRIPTION OF THE DRAWINGS

FIG. 1 is a schematic plan view of an electronic apparatus according to an embodiment as observed from above.
FIG. 2 is a plan view schematically illustrating the internal structure of a chassis.
FIG. 3 is a perspective view of a bottom surface of the chassis as observed obliquely from the rear.
FIG. 4 is a perspective view of the bottom surface of the chassis as observed obliquely from the front.
FIG. 5 is a side sectional view schematically illustrating the internal structure of the chassis including a cooling module and a peripheral area thereof.
FIG. 6 is a front sectional view schematically illustrating the internal structure of the chassis including the cooling module and the peripheral area thereof.
FIG. 7 is a side sectional view schematically illustrating the internal structure of a chassis including a cooling module having a heat diffusion member according to a modified example, and a peripheral area thereof.
FIG. 8 is a table illustrating the results of simulation experiments comparing the cooling performance of electronic apparatuses and the surface temperatures of chassis when cooling modules having different configurations are installed in the chassis.

### DETAILED DESCRIPTION OF THE INVENTION

The following will describe in detail a preferred embodiment of an electronic apparatus according to the present invention with reference to the accompanying drawings.

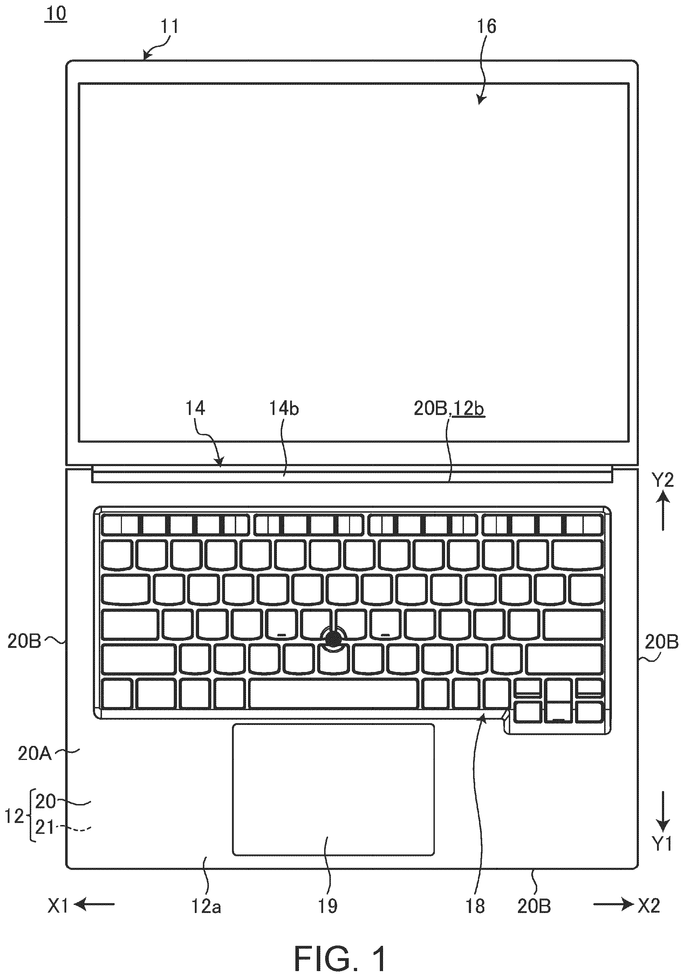

FIG. 1 is a schematic plan view of an electronic apparatus 10 according to an embodiment observed from above. As illustrated in FIG. 1, the electronic apparatus 10 of the present embodiment is a clamshell laptop PC. The electronic apparatus 10 has a configuration in which a cover body 11 and a chassis 12 are connected by a hinge 14 so as to be rotatable relative to each other. Although the present embodiment illustrates the electronic apparatus 10 as a laptop PC, the electronic apparatus may alternatively be, for example, a tablet PC, a smartphone, or a portable game machine other than the laptop PC.

The cover body 11 is a thin, flat, box-shaped chassis. The cover body 11 is provided with a display 16. The display 16 is, for example, an organic EL display or a liquid crystal display.

The chassis 12 is a thin, flat box body. A keyboard device 18 and a touchpad 19 are exposed on the upper surface (a surface 12a) of the chassis 12. Hereinafter, the chassis 12 and the components mounted thereon will be described using the posture of an operator operating the keyboard device 18 as the reference, with the width direction (left and right) of the chassis 12 being referred to as X1 and X2 directions, respectively, the depth direction (front and rear) of the chassis 12 being referred to as Y1 and Y2 directions, respectively, and the thickness direction (top and bottom) of the chassis 12 being referred to as Z1 and Z2 directions, respectively. The X1 and X2 directions may be collectively referred to as the X-direction, and similarly, the Y1 and Y2 directions and the Z1 and Z2 directions may be referred to as the Y-direction and a Z-direction, respectively. These directions are defined for the convenience of explanation, and may of course change, depending on the usage state, the installation attitude, or the like of the electronic apparatus 10.

The chassis 12 is composed of a chassis member 20, which forms the upper surface and the four peripheral side surfaces, and a cover member 21 forming the lower surface. The chassis member 20 has vertical walls 20B formed on the four peripheral edges of a cover plate 20A, which forms the surface 12a of the chassis 12. Thus, the chassis member 20 has a substantially bathtub shape with an open bottom. The cover member 21 has a substantially flat plate shape, and serves as a cover that closes the open bottom of the chassis member 20. The chassis member 20 and the cover member 21 are overlapped in the thickness direction and connected in a mutually detachable manner. The vertical walls 20B may be formed on the cover member 21. In this case, the chassis member 20 may be composed of only the cover plate 20A.

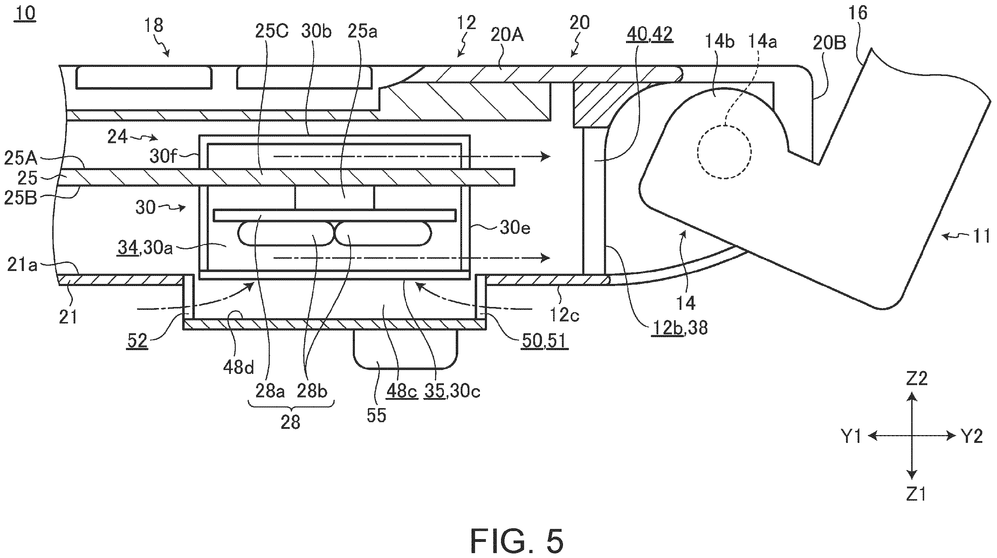

The hinge 14 is installed in a concave hinge placement groove 12b formed at the rear edge of the chassis 12, and connects the chassis 12 and the cover body 11. The hinge 14 has a structure in which, for example, a hinge shaft 14a serving as a rotating shaft is supported at both ends of a hinge chassis 14b in the longitudinal direction (refer to FIG. 5). The hinge 14 of the present embodiment is configured to have a so-called one-bar shape, with the hinge chassis 14b extending along the longitudinal direction of the hinge placement groove 12b. The hinge chassis 14b of the hinge 14 descends diagonally backward while rotating together with the cover body 11 (refer to FIG. 5). The hinge 14 has a structure that increases the rotation angle of the cover body 11 as described above, which is a so-called drop-down structure. The structure of the hinge 14 may be other than the one described above.

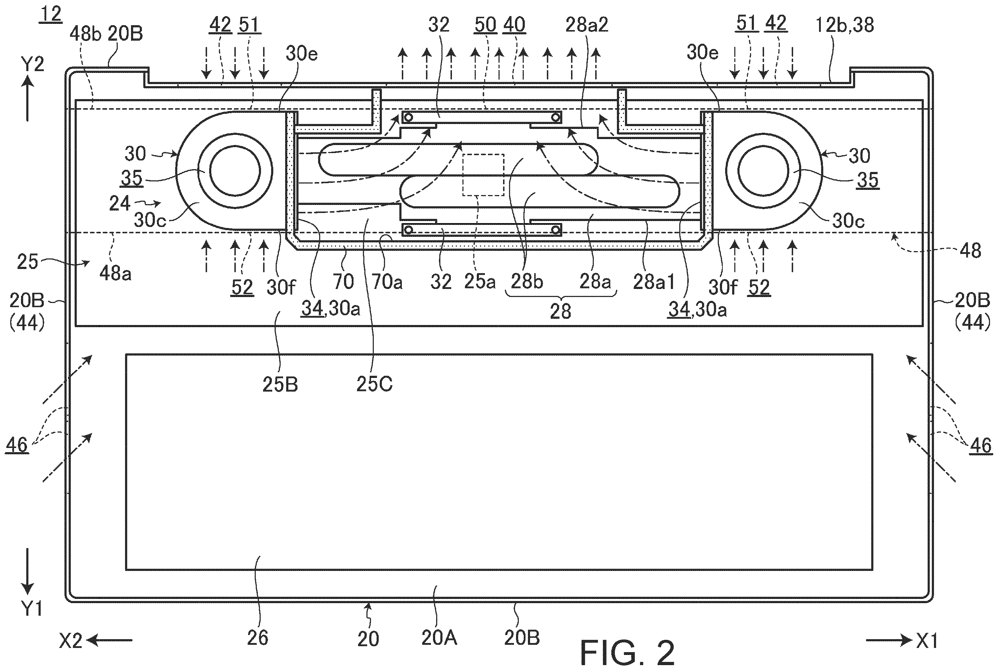

FIG. 2 is a plan view schematically illustrating the internal structure of the chassis 12. FIG. 2 is a diagram illustrating the interior of the chassis member 20 with the cover member 21 removed, which is observed from below.

As illustrated in FIG. 2, the chassis 12 includes therein a cooling module 24, a motherboard 25, and a battery device 26. Further, various electronic components, mechanical components, and the like are provided inside the chassis 12.

The motherboard (board) 25 is a circuit board serving as the main board of the electronic apparatus 10. The motherboard 25 is placed closer to a Y2 side in the chassis 12 and extends in an X-direction. The battery device 26 is a rechargeable battery that serves as a power source for the electronic apparatus 10. The battery device 26 is placed closer to a Y1 side relative to the motherboard 25 and extends in the X-direction.

The motherboard 25 of the present embodiment has a CPU (Central Processing Unit) 25a mounted thereon. In addition to the CPU 25a, the motherboard 25 can also be provided with various electronic components such as a GPU (Graphics Processing Unit), memories, and a communication module.

For example, an upper surface (a first surface 25A) of the motherboard 25 serves as the surface of attachment to the chassis member 20, and a lower surface (a second surface 25B) serves as a mounting surface for the CPU 25a or the like.

A description will now be given of a configuration example of the cooling module 24.

The CPU 25a is a heat generating element that generates the largest amount of heat among the electronic components mounted in the chassis 12. The cooling module 24 can absorb and diffuse the heat generated by the CPU 25a and discharge the heat to the outside of the chassis 12. The cooling module 24 may be configured to cool a heat generating element, such as a GPU, other than the CPU 25a.

As illustrated in FIG. 2, the cooling module 24 of the present embodiment includes a heat diffusion member 28 and a pair of fans 30, 30.

The heat diffusion member 28 is adapted to absorb and diffuse the heat of the CPU 25a. The heat diffusion member 28 has a metal plate 28a and heat pipes 28b.

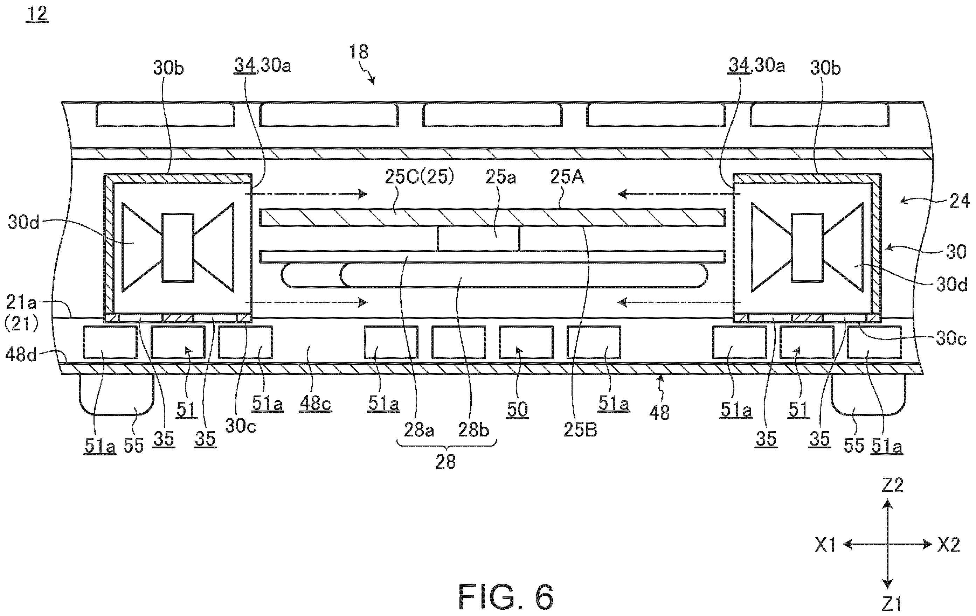

The metal plate 28a is a thin plate made of a metal such as copper, aluminum, or the like having high thermal conductivity. The metal plate 28a of the present embodiment is a copper plate. The metal plate 28a extends in the X-direction between the left and right fans 30, 30. The metal plate 28a covers a part (a part 25C) of the motherboard 25 placed between the left and right fans 30, 30, and the CPU 25a, which is mounted on the part 25C, from the second surface 25B side (a Z2 side)(refer also to FIG. 6). The metal plate 28a is connected to the surface of the CPU 25a. Thermally conductive grease and a copper block or the like having approximately the same size as the outer shape of the CPU 25a, for example, are interposed between the metal plate 28a and the CPU 25a. Leaf springs 32 are attached to edges 28a1 and 28a2 along the X-direction of the metal plate 28a. The leaf springs 32 are components that press the metal plate 28a against the CPU 25a.

The heat pipes 28b are pipe-type heat transport devices. The heat pipes 28b are metal pipes that are thinly and flatly collapsed to form elliptical cross sections, and configured by sealing a working fluid into a sealed space inside. Examples of the working fluid include water, alternative fluorocarbons, acetone, and butane. The heat pipes 28b can be used, for example, in a set of two. The heat pipes 28b are fixed to the back side of the surface of connection of the metal plate 28a to the CPU 25a. Each of the heat pipes 28b overlaps the CPU 25a in the Z-direction at around the center thereof in the longitudinal direction. This enables the heat pipes 28b to quickly diffuse the heat of the CPU 25a, which has been transferred to the metal plate 28a, more efficiently than the metal plate 28a.

The pair of fans 30, 30 are placed with the heat diffusion member 28 located therebetween in the X-direction, facing each other. The fans 30 have discharge ports 34 only in side surfaces 30a facing each other. In other words, the discharge ports 34 of the left and right fans 30 face each other with the heat diffusion member 28 therebetween. This allows the fans 30 to discharge air toward the heat diffusion member 28. In each of the fans 30, of upper and lower end surfaces 30b and 30c facing in the Z-direction, at least the end surface 30c on the Z1 side has suction ports 35. The suction ports 35 can be provided also in the end surface 30b on a Z2 side. The end surfaces 30b and 30c are surfaces that are orthogonal to the side surfaces 30a and also orthogonal to the axial direction of the rotating shafts of impellers 30d.

The fans 30 are centrifugal fans that rotate the impellers 30d accommodated in housings by motors (refer to FIG. 6). Thus, the fans 30 can discharge, through the discharge ports 34, the air drawn in through the suction ports 35.

A description will now be given of an intake/exhaust structure for introducing air into the chassis 12 by the fans 30 and exhausting the air discharged from the fans 30 to the outside of the chassis 12.

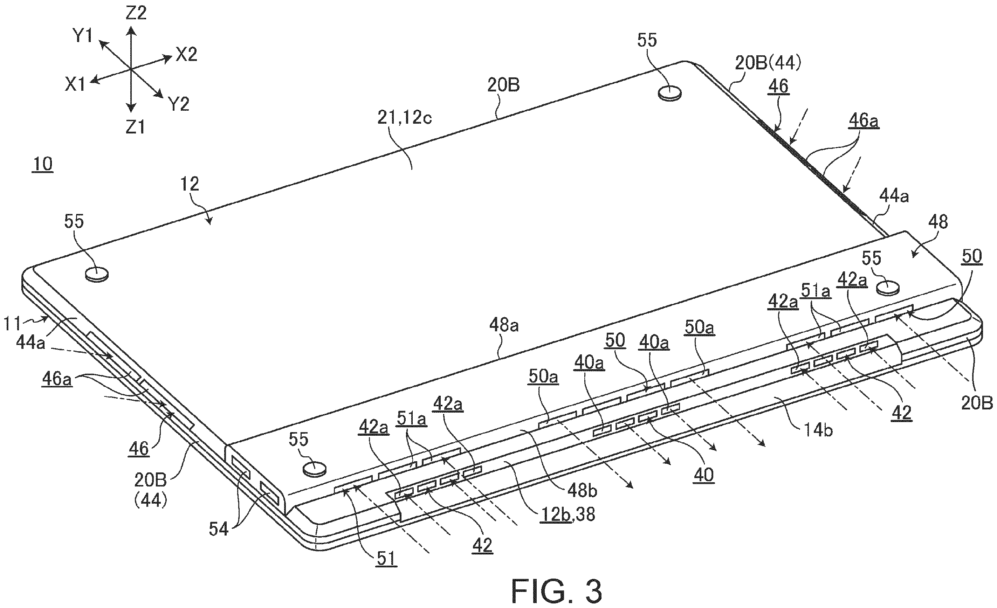

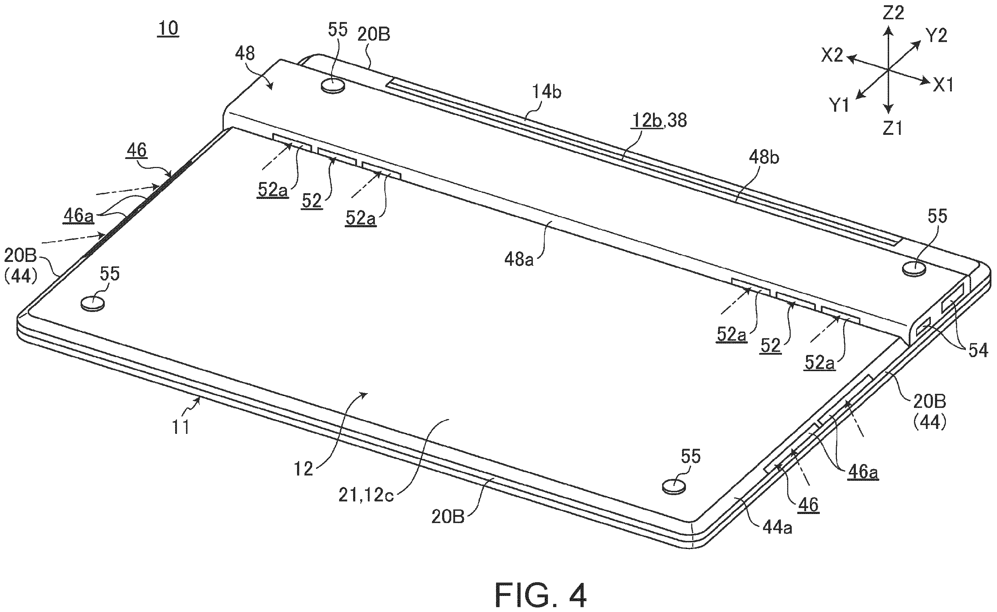

FIG. 3 is a perspective view of a bottom surface 12c of the chassis 12 as observed obliquely from the rear. FIG. 4 is a perspective view of the bottom surface 12c of the chassis 12 as observed obliquely from the front. FIG. 5 is a side sectional view schematically illustrating the internal structure of the chassis 12 including the cooling module 24 and a peripheral area thereof. FIG. 6 is a front sectional view schematically illustrating the internal structure of the chassis 12 including the cooling module 24 and the peripheral area thereof.

As illustrated in FIG. 2 to FIG. 5, the intake/exhaust structure of the electronic apparatus 10 includes an exhaust port 40 formed in a vertical wall 20B (an outer wall 38) at the rear edge (the edge on the Y2 side) of the chassis 12. The exhaust port 40 is an opening for exhausting, to the outside of the chassis 12, the air (hot air) that has been discharged through the discharge ports 34 of the fans 30 and cooled while passing along the surface of the heat diffusion member 28.

In the case of the present embodiment, the vertical wall 20B on the Y2 side extends along the longitudinal direction thereof and has a concave hinge placement groove 12b on the Y1 side. The outer wall 38 is the bottom wall (front wall) of the hinge placement groove 12b. The exhaust port 40 is provided in the vicinity of the center of the outer wall 38 in the longitudinal direction. The exhaust port 40 consists of, for example, a plurality of (four in FIG. 3) openings 40a arranged closely in the X-direction. The exhaust port 40 is positioned between the fans 30, 30 when the placement direction of the left and right fans 30, 30 (the X-direction) is used as the reference. The heat diffusion member 28 extends in the X-direction at a position close to the outer wall 38. Thus, the exhaust port 40 is close to and opposed to the edge 28a2 of the metal plate 28a on the Y2 side.

The vertical wall 20B can be configured without the hinge placement groove 12b. In this case, the exhaust port 40 can be formed in the vertical wall 20B itself, which is an outer wall. This applies also to intake ports 42, which will be described later.

The intake/exhaust structure of the electronic apparatus 10 can be provided with the intake ports 42 formed in the outer wall 38. The intake ports 42 are openings for introducing the air outside the chassis 12 into the suction ports 35 of the fans 30.

The intake ports 42, which are flush with the exhaust port 40, are formed in the outer wall 38. Each of the intake ports 42 consists of, for example, a plurality of (four in FIG. 3) openings 42a arranged closely in the X-direction. The intake ports 42 are provided in a pair, and placed with the exhaust port 40 therebetween in the longitudinal direction of the outer wall 38. The intake ports 42 are respectively positioned on the Y2 side of the left and right fans 30, 30, and in the vicinity of the left and right ends of the outer wall 38.

Neither of the fans 30 has the discharge port 34 in a side surface 30e on the Y2 side facing the outer wall 38 (refer to FIG. 2). The side surface 30e intersects with the side surface 30a in which the discharge port 34 is formed. The intake port 42 is adjacent to and opposed to the side surface 30e without the discharge port 34.

The intake/exhaust structure of the electronic apparatus 10 can have intake ports (second intake ports) 46 formed in the vertical walls 20B (side walls 44) of the side edges (the edges on the X1 and X2 sides) of the chassis 12. The intake ports 46 are openings for introducing the air outside the chassis 12 into the suction ports 35 of the fans 30.

The left and right side walls 44 extend in the Y-direction orthogonal to the X-direction, which is the longitudinal direction of the outer wall 38. Each of the side walls 44 has a vertical surface along the Z-direction, which forms the outer periphery of the chassis 12, and a tapered surface 44a, which gradually inclines from the vertical surface to the center of the chassis 12 toward the Z2 side. Each of the intake ports 46 is provided in the tapered surface 44a of each of the side walls 44. Each of the intake ports 46 consists of, for example, a plurality of (two in FIG. 3) openings 46a arranged closely in the Y-direction. The left and right intake ports 46 are positioned on the opposite side from the exhaust port 40 and the intake ports 42 with respect to the fans 30 when the longitudinal direction (the Y-direction) of the side walls 44 is used as the reference. In other words, the intake ports 46 are located at the front (the Y1 side) relative to the fans 30.

As illustrated in FIG. 2 to FIG. 6, the intake/exhaust structure of the electronic apparatus 10 can be provided with vents 50, 51, and 52 formed in a projecting part 48 provided on the bottom surface 12c of the chassis 12.

The projecting part 48 protrudes from the bottom surface 12c. The projecting part 48 is shaped like a square tube which is lengthy in the X-direction and flat in the Z-direction. The length of the projecting part 48 in the X-direction is approximately equivalent to the full width of the chassis 12 in the X-direction. The projecting part 48 is provided at a position closer to the Y2 side in the front-rear direction (the Y-direction) of the bottom surface 12c. The projecting part 48 has a pair of vertical walls 48a and 48b extending along the longitudinal direction (the X-direction) thereof. The vertical wall 48b on the Y2 side is located at the immediate front of the outer wall 38. In a plan view of the chassis 12, the projecting part 48 is placed at a position where the projecting part 48 vertically overlaps the left and right fans 30, 30 (refer to FIG. 2).

Two input/output ports 54 are provided at each of the longitudinal ends (left and right end surfaces) of the projecting part 48. Examples of the input/output ports 54 include those conforming to the HDMI (registered trademark) standard and those conforming to the USB 3.0 communication standard. This enables the electronic apparatus 10 to have the tapered surfaces 44a on the side walls 44 while allowing the installation of the input/output ports 54 that require a certain height. The projecting part 48 also functions as a rear leg that raises the rear of the chassis 12 higher than the front when the chassis 12 is placed on a placing surface such as the top surface of a desk. This allows the keyboard device 18 of the electronic apparatus 10 to be inclined downwards to the front when in use, thus improving operability. Symbol 55 in FIG. 3 to FIG. 6 denotes a rubber leg that serves as a leg when the electronic apparatus 10 is placed on a placing surface. The rubber legs 55 on the Y2 side are provided on the bottom surface of the projecting part 48.

The projecting part 48 is provided with the vents 50 to 52, thus enabling the projecting part 48 to also function as a part of the intake/exhaust structure of the electronic apparatus 10.

The vent 50 is provided in the vicinity of the center in the longitudinal direction of the vertical wall 48b on the Y2 side. The vent 50 functions as an auxiliary exhaust port of the exhaust port 40. The vent 50 consists of, for example, a plurality of (four in FIG. 3) openings 50a closely arranged in the X-direction. The vent 50 is positioned between the left and right fans 30, 30 in the X-direction. In other words, the vent 50 is located at a position where at least a part of the vent 50 overlaps the exhaust port 40 in the Y-direction.

The vents 51 are flush with the vent 50 and formed in the vertical wall 48b. The vents 51 function as auxiliary intake ports of the intake ports 42. Each of the vents 51 is composed of, for example, a plurality of (three in FIG. 3) openings 51a closely arranged in the X-direction. The vents 51 are provided in a pair and placed with the vent 50 therebetween in the longitudinal direction of the vertical wall 48b. The vents 51 are respectively positioned on the Y2 side of the left and right fans 30, 30, and in the vicinity of the left and right ends of the vertical wall 48b. In other words, the vents 51 are located at positions where the vents 51 at least partly overlap the intake ports 42 in the Y-direction.

The vents 52 are provided in the vertical wall 48a on the Y1 side. The vents 52 function as auxiliary intake ports of the intake ports 42. Each of the vents 52 is composed of, for example, a plurality of (three in FIG. 3) openings 52a closely arranged in the X-direction. The vents 52 are provided in a pair and respectively located on the Y1 side of the left and right fans 30, 30 in the X-direction. The vents 52 are respectively provided in the vicinity of the left and right ends of the vertical wall 48a. Neither of the fans 30 has the discharge port 34 also in the side surface 30f on the Y1 side, which faces the vent 52.

As illustrated in FIG. 5 and FIG. 6, the end surface 30c, in which the suction port 35 of each of the fans 30 is formed, faces an inner space 48c of the projecting part 48. Hereinafter, the end surface 30c may be referred to as the "suction surface 30c." The inner space 48c is a groove-shaped space that is deeper on the Z2 side by the height of the projecting part 48 from an inner surface 21a of the cover member 21 that forms the bottom surface 12c. In other words, the inner space 48c expands the internal space of the chassis 12 in the Z-direction.

The suction surface 30c is a surface facing the Z2 side, and placed so as to cover the upper part of the inner space 48c. This enables the fans 30 to smoothly draw in, through the suction ports 35, the air outside the chassis 12 through the vents 50 and 51 provided in the vertical walls 48a and 48b. Preferably, a part of each of the fans 30 in the thickness direction, i.e., the suction surface 30c, is inserted in the inner space 48c.

The depth of the inner space 48c, i.e., the height in the Z2 direction from the inner surface 21a of the cover member 21 to an inner bottom surface 48d of the projecting part 48, can be set to, for example, approximately 2.5 to 4 mm. The height in the Z2 direction from the inner surface 21a to the suction surface 30c can be set to, for example, approximately 0.5 to 1.5 mm. At this time, a gap of 1 mm or more is preferably secured between the suction surface 30c and the inner bottom surface 48d. This enables the fans 30 to further smoothly draw in, through the suction ports 35, the air that has been introduced into the inner space 48c through the vents 50 and 51. In addition, the presence of the inner space 48c immediately below the fans 30 makes it possible to increase the thicknesses of the fans 30, thereby increasing the air volume of the fans 30. The suction surface 30c may be positioned to the Z1 side relative to the inner surface 21a.

Providing the fans 30 with the suction ports 35 also in the end surface 30b on the Z2 side as well as the end surface 30c on the Z1 side enables the fans 30 to further smoothly draw in air outside the chassis 12 also through the intake ports 42 provided in the outer wall 38.

A description will now be given of the cooling action of the cooling module 24. The chain-line arrows shown in FIG. 2 to FIG. 6 schematically illustrate the flows of air.

In the electronic apparatus 10, the heat generated from a heat generating element such as the CPU 25a is transmitted to the heat diffusion member 28 and efficiently diffused. The fans 30 located on both sides of the heat diffusion member 28 draw outside air (cool air) into the suction ports 35 through the intake ports 42, and discharge the air through the discharge ports 34. The fans 30 can draw in outside air (cool air) also through the intake ports 46 and the vents 51 and 52.

The air discharged through the discharge ports 34 of the left and right fans 30 flows along the surface of the heat diffusion member 28 to cool the heat diffusion member 28 and directly cools the electronic components of the CPU 25a at the same time. The air (hot air) that has been cooled is exhausted to the outside of the chassis 12 through the exhaust port 40, which opens at the center of the outer wall 38. A part of the hot air can be exhausted to the outside of the chassis 12 also through the vent 50.

The heat diffusion member 28 is not limited to the above-described configuration that includes the metal plate 28a and the heat pipes 28b, insofar as a configuration can diffuse the heat from a heat generating element such as the CPU 25a.

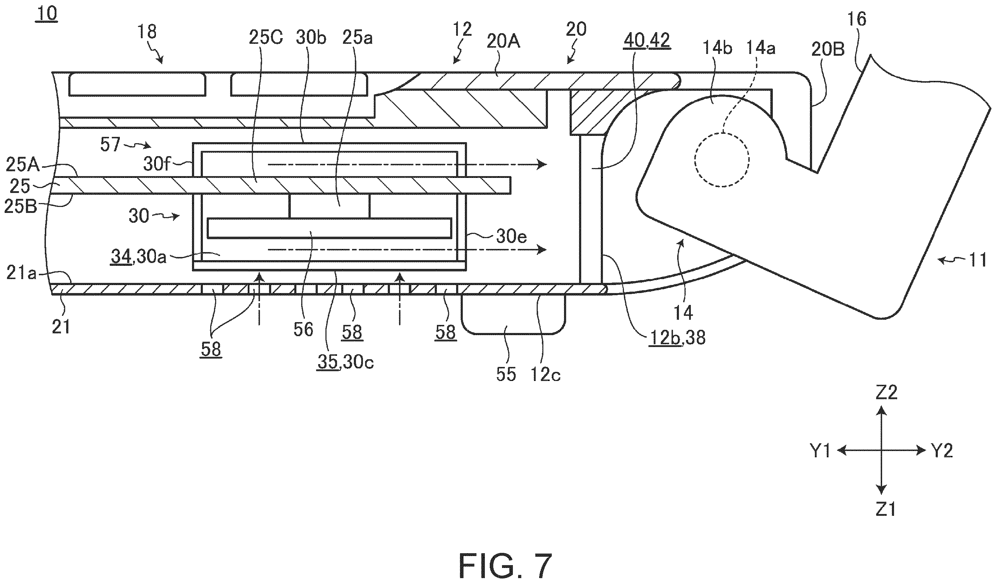

FIG. 7 is a side sectional view schematically illustrating the internal structure of the chassis 12 that includes a cooling module 57 having a heat diffusion member 56 according to a modified example, and a peripheral area of the cooling module 57.

The cooling module 57 illustrated in FIG. 7 includes a heat diffusion member 56, which has a different configuration from that of the heat diffusion member 28, as compared with the cooling module 24 illustrated in FIG. 2, FIG. 5 and FIG. 6. The heat diffusion member 56 is a vapor chamber. Hereinafter, the heat diffusion member 56 may be referred to also as "the vapor chamber 56."

The vapor chamber 56 is a plate-type heat transport device. The vapor chamber 56 is formed of a sealed space between two thin metal plates, with a working fluid sealed in the sealed space. A working fluid that is the same as or similar to that for the heat pipes 28b described above can be used. The vapor chamber 56 has a significantly higher thermal conductivity than the metal plate 28a described above.

The vapor chamber 56 can be installed in approximately the same area as the above-described metal plate 28a. Thus, the vapor chamber 56 covers the part 25C and the CPU 25a of the motherboard 25 between the left and right fans 30, 30 from the second surface 25B side (the Z2 side). The vapor chamber 56 is connected to the surface of the CPU 25a via thermally conductive grease, a copper block, or the like in the same manner as the above-described metal plate 28a. This enables the vapor chamber 56 to efficiently absorb and quickly diffuse the heat from the CPU 25a.

The projecting part 48 may be omitted. The electronic apparatus 10 illustrated in FIG. 7 illustrates a configuration in which the chassis 12 is not provided with the projecting part 48. In this case, the bottom surface 12c of the cover member 21 in the chassis 12 is preferably provided with intake ports 58. The intake ports 58 are openings formed at positions where the openings vertically overlap the suction surface 30c of each of the fans 30. The intake ports 58 are adjacent to and opposed to suction ports 35 of the fans 30. This enables the fans 30 to draw in outside air at the suction ports 35 through the intake ports 58.

The vapor chamber 56 may be applied to the configuration that includes the projecting part 48 illustrated in FIG. 6. The cooling module 57 may be installed in the chassis 12 having the configuration that includes the projecting part 48.

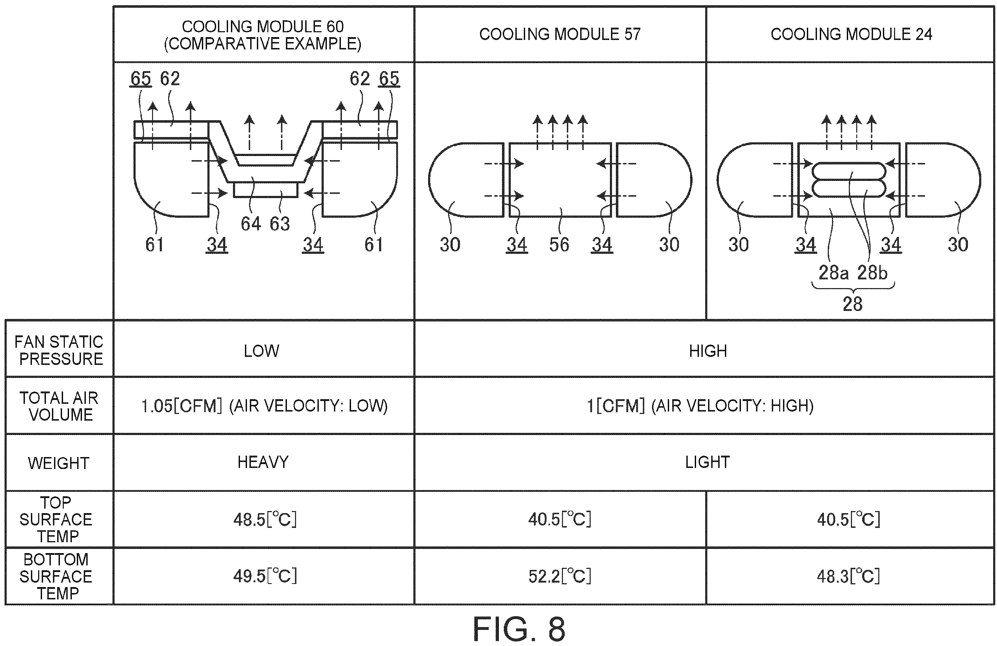

The operation and effect of the electronic apparatus 10 of the present embodiment will now be described with reference to FIG. 8.

FIG. 8 is a table illustrating the results of a simulation experiment comparing the cooling performance of an electronic apparatus and the surface temperature of the chassis 12 when cooling modules having different configurations are mounted in the chassis 12.

In FIG. 8, the right column "Cooling module 24" shows the experimental results for the cooling module 24 provided with the heat diffusion member 28. The middle column "Cooling module 57" shows the experimental results for the cooling module 57 provided with the heat diffusion member 56.

The left column "Cooling module 60" in the left column is a comparative example, and shows the experimental results of a cooling module similar to that of a prior art. The cooling module 60 has a configuration in which heat sinks 62 are placed behind left and right fans 61. The heat of a heat generating element such as the CPU 25a is transmitted to a heat pipe 64 via a copper plate 63 and efficiently transported to the left and right heat sinks 62 by the heat pipe 64. Therefore, the fans 61 of the cooling module 60 have, in addition to the discharge ports 34 facing the copper plate 63, second discharge ports 65 facing the heat sinks 62.

In FIG. 8, "Fan static pressure" indicates the evaluation of the magnitude of the static pressure of the fans 30. "Total air volume" indicates the total air volume (CFM) of the left and right fans 30, 30 (61, 61). "Weight" indicates the evaluation of the magnitude of the weight of each of the cooling module 24, 57, and 60. "Top surface temperature" indicates the temperature (°C) of a high-temperature part on the surface 12a of the chassis 12. "Bottom surface temperature" indicates the temperature (°C) of a high-temperature part on the bottom surface 12c of the chassis 12.

It has been found from the experiment results that, as compared with the cooling module 60 of the comparative example, the cooling modules 24 and 57 of the present embodiment have a higher static pressure of the fans 30 and a faster air velocity, while the total air volume of the fans 30 (61) remains almost the same. The cooling modules 24 and 57 of the present embodiment also have the advantage of being lighter in weight than the cooling module 60 of the comparative example due to the absence of the heat sinks 62.

Further, it has been found that the cooling modules 24 and 57 of the present embodiment have a significantly lower top surface temperature than the cooling module 60 of the comparative example. This means that, in the electronic apparatus 10 of the present embodiment, the temperatures of the keyboard device 18 and the surface 12a of the surroundings thereof, which are often hand-touched directly by an operator, are significantly reduced. Thus, it has been verified that the usability of the electronic apparatus 10 is significantly improved. Here, one of the reasons why the top surface temperature of the cooling module 60 in the comparative example is high is considered to be that the heat from the CPU 25a is concentrated on the heat sinks 62, resulting in a localized high temperature area on the surface 12a directly above the heat sinks 62.

It has been found that the bottom surface temperatures in the cooling modules 24 and 57 of the present embodiment hardly change, as compared with the cooling module 60 of the comparative example. More specifically, it has been found that, as compared with the cooling module 60, the top surface temperature of the cooling module 24 reduces, while the top surface temperature of the cooling module 57 is slightly higher.

Thus, the cooling performance of the cooling modules 24 and 57 of the present embodiment can reduce the top surface temperature particularly required to be suppressed, while securing the cooling capability that is equal to or better than that of the cooling module 60 provided with the conventional heat sinks 62. In particular, the cooling module 24 using the heat diffusion member 28 has been verified to have extremely effective cooling performance.

As described above, the electronic apparatus 10 of the present embodiment includes the cooling module 24 (57), which is provided in the chassis 12 and cools a heat generating element (e.g., CPU 25a). The cooling module 24 (57) includes the heat diffusion member 28 (56), which absorbs and diffuses the heat of a heat generating element, and a pair of fans 30, 30. The pair of fans 30, 30 are placed with the heat diffusion member 28 (56) located therebetween, and have discharge ports 34 only in the side surfaces 30a facing each other, thereby making it possible to discharge air toward the heat diffusion member 28 (56). The chassis 12 has the outer wall 38, which extends along the placement direction of the fans 30, 30 (the X-direction) and has the exhaust port 40 formed therein. The exhaust port 40 is positioned between the pair of fans 30, 30 when the X-direction is used as the reference.

Thus, in the electronic apparatus 10, the discharge ports 34 of the fans 30 are located in a direction such that the discharge ports 34 face each other. The air blow from the discharge ports 34 passes the surface of the heat diffusion member 28 (56) and is exhausted to the outside of the chassis 12 through the exhaust port 40 located behind the heat diffusion member 28 (56). This enables the electronic apparatus 10 to quickly diffuse the heat from the heat generating element by the heat diffusion member 28 (56), while directly cooling the diffused heat with the air blow from the fans 30. This makes it possible for the electronic apparatus 10 to avoid the situation in which the heat from a heat generating element is concentrated on the heat sinks 62, as in the conventional cooling module 60, causing the surface temperature of the chassis 12 directly above or below the heat sinks 62 to become locally high. As a result, the electronic apparatus 10 can suppress the surface temperature of the chassis 12 even if, for example, the chassis 12 is made thinner, thus improving the usability. In addition, the cooling module 24 (57) does not require heat sinks, which are usually placed between fans and an exhaust port of the chassis. This reduces the weight of the cooling module 24 (57). Further, the electronic apparatus 10 has a smaller space occupied by the cooling module 24 (57) in the chassis 12. As a result, the electronic apparatus 10 has improved space efficiency inside the chassis 12, thus enlarging an installation space for various devices such as the battery device 26, and antennas for wireless communication.

The chassis 12 can have the intake ports 42, which are flush with the exhaust port 40 and formed in the outer wall 38 and which face the side surfaces 30e of the fans 30, the side surfaces 30e having no discharge ports. This makes it possible for the electronic apparatus 10 to, for example, omit the intake ports 58 that open in the bottom surface 12c illustrated in FIG. 7 or reduce the opening area, thus leading to improved appearance quality of the chassis 12. The reason why the exhaust port 40 and the intake ports 42 can be formed in the same surface as described above is as follows: the cooling module 24 (57) does not have the heat sinks 62 like the conventional cooling module 60. Therefore, the chassis 12 does not need to have an exhaust port for the hot air that has passed through the heat sinks immediately after the fans 30, and the intake ports 42 can be formed in this free space.

As illustrated in FIG. 2, a space (duct structure 70) for smoothing the flow of air from the fans 30 can be formed inside the chassis 12. The duct structure 70 is a space surrounded by an airtight wall 70a. The airtight wall 70a is a member formed of, for example, sponge or rubber shaped into a strip. The airtight wall 70a is not required to completely shut off the passage of air, but required to have a certain degree of ventilation resistance to regulate the direction of air flow. The airtight wall 70a stands, for example, between the first surface 25A of the motherboard 25 and the lower surface of the keyboard device 18, and between the second surface 25B and the inner surface 21a of the cover member 21, respectively.

The range of the duct structure 70 is formed, for example, in the Z-direction between the first surface 25A of the motherboard 25 and the keyboard device 18, and between the second surface 25B and the inner bottom surface 48d of the projecting part 48. The range of the duct structure 70 is formed, for example, in the X-direction between the left and right fans 30, 30. The range of the duct structure 70 is formed in the Y-direction between the exhaust port 40 and the vertical wall 48a on the Y1 side of the projecting part 48.

With this arrangement, the air from the discharge ports 34 of the fans 30 flows inside the duct structure 70 and is smoothly exhausted to the exhaust port 40 or the vent 50. As a result, the electronic apparatus 10 can prevent the hot air that has cooled the heat diffusion member 28 (56) and the heat generating element (the CPU 25a) from flowing back to the suction ports 35 of the fans 30 in the chassis 12, thus further improving the cooling efficiency.

As illustrated in FIG. 5 to FIG. 7, the part 25C of the motherboard 25 can be positioned at the middle of the height of the discharge port 34 when the thickness direction (the Z-direction) of the fan 30 is taken as the reference. This allows the cool air from the discharge port 34 of the fan 30 to smoothly flow between the keyboard device 18 and the first surface 25A of the motherboard 25, and between the second surface 25B of the motherboard 25 and the inner surface 21a or the inner space 48c. This enables the electronic apparatus 10 to further reduce the surface temperature of the chassis 12.

The chassis 12 can have the intake port 46 in each of the left and right side walls 44, which are orthogonal to the outer wall 38 provided with the intake ports 42. This increases the intake volume of the fans 30 and increase the discharge air volume, thus further improving the cooling capacity of the cooling module 24 (57).

The chassis 12 can have the projecting part 48, which is provided protruding from the bottom surface 12c and extends along the placement direction of the fans 30, 30 (the X-direction). The projecting part 48 can have the vents 50 to 52 formed in one or both of the pair of vertical walls 48a and 48b extending along the longitudinal direction of the projecting part 48. This allows each of the vents 50 to 52 to function as an exhaust port or an intake port depending on the placement thereof.

Here, the electronic apparatus 10 has no heat sink between the fans 30 and the outer wall 38, so that the fans 30 are placed closer to the outer wall 38 by the width of the heat sinks. Thus, in the electronic apparatus 10, the Y-direction position of the projecting part 48, which is located at a position where the projecting part 48 vertically overlaps with the fans 30, can be set as far back as possible. This makes it possible to place the projecting part 48 in the vicinity of the rear end of the bottom surface 12c in the electronic apparatus 10, thus improving the design coherence on the bottom surface 12c side with resultant improved appearance quality.

It is needless to say that the present invention is not limited to the embodiment described above, and modifications can be freely made within the scope not departing from the gist of the present invention.

### Description of Symbols

10 electronic apparatus
11 cover body
12 chassis
16 display
18 keyboard device
24, 57, 60 cooling module
25 motherboard
25a CPU
28, 56 heat diffusion member
30, 61 fan
34 discharge port
35 suction port
38 outer wall
40 exhaust port
42, 46, 58 intake port
48 projecting part
50 to 52 vent

## Claims

1. An electronic apparatus (10) comprising:
a chassis (12);
a heat generating element (25a) provided in the chassis; and
a cooling module (24, 57, 60) provided in the chassis for cooling the heat generating element,
wherein the cooling module comprises:
a heat diffusion member (28, 56) arranged to absorb and diffuse heat from the heat generating element; and
a pair of fans (30, 61) arranged with the heat diffusion member located therebetween, the pair of fans comprising discharge ports in side surfaces facing each other, thereby, in use, discharging air toward the heat diffusion member, wherein
the chassis comprises an outer wall (38) that extends along a placement direction of the pair of fans and comprises an exhaust port (40) formed therein, and
the exhaust port is positioned between the pair of fans in the case where the placement direction is taken as a reference.

2. The electronic apparatus according to claim 1,
wherein the fans comprise suction ports (35) provided in end surfaces orthogonal to the side surfaces, and
the chassis comprises an intake port (42, 46, 58) which is flush with the exhaust port and formed in the outer wall, and faces a side surface of the fan that does not comprise a discharge port.

3. The electronic apparatus according to claim 2, further including:
a cover body (11) with a display (16) attached thereto; and
a hinge (14) arranged to rotatably connect one edge portion of the chassis, on which the outer wall is provided, and the cover body.

4. The electronic apparatus according to claim 3, further including:
a board (25) comprising at least a part (25C) thereof arranged between the pair of fans and comprising the heat generating element mounted on a portion thereof arranged between the pair of fans, wherein
the board is positioned at the middle of a height of the discharge port in the case where a thickness direction of the fan is taken as a reference.

5. The electronic apparatus according to claim 3 or 4,
wherein the chassis comprises a pair of side walls (44) which extend in a direction orthogonal to a longitudinal direction of the outer wall, and each of which comprises a second intake port (46) formed therein, and
the second intake port is positioned on the opposite side from the exhaust port and the intake port with respect to the fans in the case where the longitudinal direction of the side walls is taken as a reference.

6. The electronic apparatus according to any one of claims 1 to 4,
wherein the heat diffusion member comprises a heat pipe (28b) connected to a surface of a metal plate (28a), or a vapor chamber (56).

7. The electronic apparatus according to any one of claims 1 to 4,
wherein the chassis comprises a projecting part (48) which is provided in such a manner as to protrude from a bottom surface (12c) and extend along the placement direction, and
the projecting part comprises a pair of vertical walls (48a, 48b) which extend along the longitudinal direction thereof, and at least one of the pair of vertical walls comprises vents (50, 51, 52) formed therein.

8. The electronic apparatus according to claim 7,
wherein at least one vent is located at a position corresponding to at least one of the exhaust port and the pair of fans, with the longitudinal direction of the projecting part being taken as a reference.
